(19)

Europäisches
Patentamt

European
Patent Office

Office européen
des brevets

(11) **EP 2 255 906 B1**

(12) **EUROPEAN PATENT SPECIFICATION**

(45) Date of publication and mention
of the grant of the patent:
**01.10.2014 Bulletin 2014/40**

(21) Application number: **09010398.7**

(22) Date of filing: **12.08.2009**

(51) Int Cl.:
*B22F 1/00* *(2006.01)*          *B22F 3/14* *(2006.01)*
*B22F 3/16* *(2006.01)*          *B22F 9/04* *(2006.01)*
*B01J 3/06* *(2006.01)*          *H01L 35/16* *(2006.01)*
*H01L 35/18* *(2006.01)*          *H01L 35/22* *(2006.01)*
*H01L 35/34* *(2006.01)*

(54) **Fabrication of high performance densified nanocrystalline bulk thermoelectric materials using high pressure sintering technique**

Herstellung von hochleistungsverdichtetem nanokristallinem thermoelektrischem Grundmaterial unter Verwendung von Hochdrucksintertechnik

Fabrication de matériaux thermoélectriques en vrac nanocristallins densifiés et haute performance, utilisant une technique de frittage à haute pression

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **19.05.2009 CN 200910143189**

(43) Date of publication of application:
**01.12.2010 Bulletin 2010/48**

(73) Proprietor: **Yanshan University
Qinhuangdao
Hebei 066004 (CN)**

(72) Inventors:
• **Tian, Yongjun**
  **Qinhuangdao City**
  **Hebei 066004 (CN)**
• **Yu, Fengrong**
  **Qinhuangdao City**
  **Hebei 066004 (CN)**
• **Yu, Dongli**
  **Qinhuangdao City**
  **Hebei 066004 (CN)**
• **Zhang, Jianjun**
  **Qinhuangdao City**
  **Hebei 066004 (CN)**
• **Xu, Bo**
  **Qinhuangdao City**
  **Hebei 066004 (CN)**

• **Liu, Zhongyuan**
  **Qinhuangdao City**
  **Hebei 066004 (CN)**
• **He, Julong**
  **Qinhuangdao City**
  **Hebei 066004 (CN)**

(74) Representative: **Wegner, Hans
Bardehle Pagenberg Partnerschaft mbB
Patentanwälte, Rechtsanwälte
Postfach 86 06 20
81633 München (DE)**

(56) References cited:
**EP-A1- 0 522 182          EP-A1- 1 074 512
WO-A2-2008/048302          JP-A- 2003 012 308
JP-A- 2006 269 871          JP-A- 2008 108 795
US-A1- 2008 202 575**

• **FENGRONG YU, JIANJUN ZHANG, DONGLI YU, JULONG HE, ZHONGYUAN LIU, BO XU, AND YONGJUN TIAN: "Enhanced thermoelectric figure of merit in nanocrystalline Bi2Te3 bulk" J. APPL. PHYS., vol. 105, 094303, 1 May 2009 (2009-05-01), pages 1-5, XP002572318**
• **TAICHAO SU ET AL.: "Enhanced thermoelectric performance of AgSbTe2 synthesized by high pressure and high temperature" J. APPL. PHYS., vol. 105, 073713, 15 April 2009 (2009-04-15), pages 1-4, XP002572319**

EP 2 255 906 B1

**Description**

FIELD OF THE INVENTION

The present invention is related to the area of thermoelectricity, and in particular related to the fabrication of high-performance densified nanocrystalline bulk thermoelectric materials using high pressure sintering technique.

BACKGROUND OF THE INVENTION

Recently, there has been heightened interest in energy industry to find high-efficient and pollution-free energy conversion methods due to concerns of environmental protection, utilization of waste heat, as well as special demands from industry and military applications. Thermoelectric materials can directly convert heat (temperature difference) to electricity (electric voltage) and vice versa. Thermoelectric devices based on these materials have the advantages of small, quiet, pollution-free, no moving parts, and maintenance-free. Therefore, thermoelectric materials have great application potential in the field of power generation and electronic refrigeration.

The performance of a thermoelectric material is characterized with the dimensionless figure of merit, ZT, which is defined as

$$ZT = \alpha^2 \sigma T / \kappa$$

where $\alpha$, $\sigma$, T, and $\kappa$ are the Seebeck coefficient, electrical conductivity, temperature, and thermal conductivity, respectively. High-efficient thermoelectric materials should have high electrical conductivities to reduce Joule heat loss, and high Seebeck coefficients as well as low thermal conductivities to maintain the thermal energy at the junction. However, it has been a challenge to increase ZT to a value greater than 2 for decades since optimization of one physical parameter often adversely affects others.

Recent researches and developments of thermoelectric materials have suggested that ZT can be enhanced in nanostructured thermoelectric materials. Dresselhuass and Hicks *et al.* have theoretically proved a simultaneous increase in the power factor ($\alpha^2\sigma$) and decrease in the thermal conductivities in nanocomposite samples due to carrier energy filter effect, quantum confinement effect, as well as the presence of a large amount of grain boundaries. A series of research works has been performed on nanostructured materials. Such as "Thin-Film Thermoelectric Devices With High Room-Temperature Figures Of Merit" (Ventkatasubramanian et al. Nature, 413, 597, 2001), "Quantum Dot Superlattice Thermoelectric Materials and Devices" (Harman et al. Science, 297, 2229, 2002), and "Nanostructured Thermoelectric Materials" (Harman et al. Journal of Electronic Materials, 34, L19, 2005). These researches are focused on increasing ZT values with superlattice or quantum dot superlattice structures. Although exciting results have been achieved with these methods, they cannot provide a practical fabrication method for high-performance densified bulk thermoelectric materials to meet the urgent demands for high thermoelectric conversion efficiency.

The US Patent Application Publication No. US 2008/0 202 575 A1 discloses a method to fabricating thermoelectric materials with high figures of merit (ZT). The method comprises generating a plurality of nanoparticles from a thermoelectric material and consolidating the nanoparticles under pressure at an elevated temperature to form a densified thermoelectric material. The thermoelectric material has a higher ZT than the thermoelectric starting material at least at one temperature.

The European Patent Application EP 1074 512 A1 provides a clathrate compound which can be used as a thermoelectric material, a hard material, or a semiconductor material. Atoms of an element from group 4B of the periodic table are formed into a clathrate lattice, and a clathrate compound is then formed in which specified doping atoms are encapsulated within the clathrate lattice, and a portion of the atoms of the clathrate lattice are substituted with specified substitution atoms. Suitable doping atoms are atoms from groups 1A, 2A, 3A, 1B, 2B, 3B, 4A, 5A, 6A, and 8, suitable substitution atoms are atoms from groups 1A, 2A, 3A, 1B, 2B, 3B, 5A, 6A, 7A, 5B, 6B, 7B, and group 8 of the periodic table.

The article "Enhanced thermoelectric figure of merit in nanocrystalline Bi2Te3 bulk" of F. Yu et al., J. of Appl. Phys, 105, 094303, May 1st, 2009, p. 1-5 describes synthesizing of nanocrystalline $Bi_2Te_3$ bulks via a nanostructuring method that included the steps of ball milling, cold pressing, and sintering. In the temperature range of 325-525K, nanocrystalline $Bi_2Te_3$ bulks exhibit good thermoelectric properties with a peak ZT of 0.94.

The article "Enhanced thermoelectric performance of AgSbTe2 synthesized by high pressure and high temperature" of T. Su et al., J. of Appl. Phys, 105, 073713, April 15th, 2009, p. 1-4 reports on the near single phase ternary bulk thermoelectric material $AgSbTe_2$ which was synthesized by a high pressure and high temperature (HPHT) method. The HPHT synthesized $AgSbT_2$ sample has higher thermoelectric performance in the measured temperature range than that of the same sample prepared at normal pressure. The enhanced thermoelectric properties should be attributed to the HPHT quenching which keeps partially the high electrical conductivity of $AgSbTe_2$ under high pressure.

SUMMARY OF THE INVENTION

To solve the dilemma faced with methods mentioned above, an object of the present invention is to provide a feasible method to fabricate high-performance densified nanocrystalline bulk thermoelectric materials using high pressure sintering technique. The bulk thermoelectric materials fabricated with the method according to the present invention exhibit a low thermal conductivity and a high ZT value, which is higher than 2.

The key of the present invention to overcome the technical barriers lies on the control and adjustment of microstructure of a thermoelectric material. With ball milling and high pressure sintering technique, bulk materials with small average crystal grain size (10 - 50 nm) and high relative density (90 - 100%) can be achieved. The thermoelectric properties of thus fabricated materials are highly improved. According to the present invention, the technique includes steps of preparation of nanopowders with well-controlled purity and size through ball milling, and sintering the pressed powder under a high pressure. The microstructure and grain size of the final bulk materials are controlled through tuning the sintering parameters (pressure, temperature, process time).

The fabrication method of high-performance densified nanocrystalline bulk thermoelectric materials according to the invention comprises the following steps.

1. Preparation of nanopowders

A thermoelectric alloy is prepared by melting or mechanical alloying process using the corresponding elemental substances as raw materials, and the melting point of the alloy is $T_m$. Then, the alloy is ball milled under an inert atmosphere or vacuum to produce alloy powders with an average grain size of 5 - 30 nm.

2. High pressure sintering

a) The milled nanopowders are pressed into a preform under an inert atmosphere or vacuum.
b) Placing the preform into a high pressure sintering mold and sintering the preform at a temperature of 0.25 - 0.8 $T_m$ under a pressure of 1.0 - 5.0 GPa for 10 - 120 - minutes, to obtain a nanocrystalline bulk thermoelectric material having a relative density of 90 - 100 % and an average grain size of 10 - 50 nm; and
c) Performing an annealing step after the high pressure sintering step.

With the fabrication method presented in this invention, high-performance densified nanocrystalline bulk thermoelectric materials with a ZT value equal to or higher than 2 can be achieved.

Other features and advantages of the present invention will be demonstrated in detailed description below. It should be understood, however, that the detailed description and the specific examples, while indicating preferred embodiments of the invention, are given by way of illustration only, since various changes and modifications within the spirit and scope of the invention will become apparent to those skilled in the art from this detailed description.

BRIEF DESCRIPTION OF THE DRAWINGS

The following drawings form part of the present specification and are included to further demonstrate certain aspects of the present invention. The invention may be better understood by reference to one or more of these drawings in combination with the detailed description of specific embodiments presented herein:

Figure 1 is a graph showing the thermal conductivity vs. temperature characteristics for the thermoelectric alloy samples obtained according to Examples 1 and 2 of the present invention, a $Bi_2Te_3$ nanocrystalline bulk thermoelectric alloy prepared with normal pressure sintering method, and a large crystal grain $Bi_2Te_3$ bulk thermoelectric alloy prepared with zone melting process, respectively.

Figure 2 is a graph showing the electrical resistivity vs. temperature characteristics for the thermoelectric alloy samples obtained according to Examples 1 and 2 of the present invention, a $Bi_2Te_3$ nanocrystalline bulk thermoelectric alloy prepared with normal pressure sintering method, and a large crystal grain $Bi_2Te_3$ bulk thermoelectric alloy prepared with zone melting process, respectively.

Figure 3 is a graph showing the Seebeck coefficient vs. temperature characteristics for the thermoelectric alloy samples obtained according to Examples 1 and 2 of the present invention, a $Bi_2Te_3$ nanocrystalline bulk thermoelectric alloy prepared with normal pressure sintering method, and a large crystal grain $Bi_2Te_3$ bulk thermoelectric alloy prepared with zone melting process, respectively.

Figure 4 is a graph showing the ZT value vs. temperature characteristics for the thermoelectric alloy samples obtained according to Examples 1 and 2 of the present invention, a $Bi_2Te_3$ nanocrystalline bulk thermoelectric alloy prepared with normal pressure sintering method, and a large crystal grain $Bi_2Te_3$ bulk thermoelectric alloy prepared with zone melting process, respectively.

Figure 5 is a graph showing the thermal conductivity vs. temperature characteristics for the sample obtained according to Example 3 of the present invention.

Figure 6 is a graph showing the electrical resistivity vs. temperature characteristics for the sample obtained according to Example 3 of the present invention.

Figure 7 is a graph showing the Seebeck coefficient vs. temperature characteristics the sample obtained according to Example 3 of the present invention.

Figure 8 is a graph showing the ZT value vs. temperature characteristics the sample obtained according to Example 3 of the present invention.

Figure 9 is a graph showing the thermal conductivity vs. temperature characteristics for the sample obtained according to Example 4 of the present invention.

Figure 10 is a graph showing the electrical resistivity vs. temperature characteristics for the sample obtained according to Example 4 of the present invention.

Figure 11 is a graph showing the Seebeck coefficient vs. temperature characteristics the sample obtained according to Example 4 of the present invention.

Figure 12 is a graph showing the ZT value vs. temperature characteristics the sample obtained according to Example 4 of the present invention.

Figure 13 is a graph showing the thermal conductivity vs. temperature characteristics for the sample obtained according to Example 5 of the present invention.

Figure 14 is a graph showing the electrical resistivity vs. temperature characteristics for the sample obtained according to Example 5 of the present invention.

Figure 15 is a graph showing the Seebeck coefficient vs. temperature characteristics the sample obtained according to Example 5 of the present invention.

Figure 16 is a graph showing the ZT value vs. temperature characteristics the sample obtained according to Example 5 of the present invention.

Figure 17 is a graph showing the thermal conductivity vs. temperature characteristics for the sample obtained according to Example 6 of the present invention.

Figure 18 is a graph showing the electrical resistivity vs. temperature characteristics for the sample obtained according to Example 6 of the present invention.

Figure 19 is a graph showing the Seebeck coefficient vs. temperature characteristics the sample obtained according to Example 6 of the present invention.

Figure 20 is a graph showing the ZT value vs. temperature characteristics the sample obtained according to Example 6 of the present invention.

## DETAILED DESCRIPTION OF THE INVENTION

### 1. Preparation of nanopowders

The method according to the present invention is a general method applicable to all kinds of thermoelectric materials known in the art, including stoichiometric thermoelectric compounds, non-stoichiometric thermoelectric solid solution alloys, and doped thermoelectric alloys. Examples of thermoelectric alloys suitable for the present invention include, but not limited to, $(Bi,Sb)_2(Te,Se)_3$ based materials, PbTe based materials, $Bi_{1-x}Sb_x$ solid solutions (0<x<1), SiGe based alloys, Skutterudte crystalline compounds, etc. These materials can be prepared according to any method known in the art. For example, these thermoelectric compounds or solid solution alloys can be produced by a mechanical alloying or melting process from the corresponding elemental substances, including metals and non-metals, such as Bi, Te, Sb, Se, Pb, Co, Si, Ge, Fe, Cd, Sn, La, Ce, Ag, Sr, P, etc. The selection of suitable elemental substances and the details of the alloying or melting process are well known by those skilled in the art, and will not be described further herein in order not to unnecessarily obscure embodiments of the present invention.

The elemental materials employed in the present invention usually have a purity higher than 90%, preferably higher than 95%, more preferably higher than 99%, even more preferably higher than 99.9%, and the most preferably higher than 99.99%.

The thermoelectric alloy materials especially suitable for the methods according to the present invention include, but not limited to: binary alloys, such as $Bi_2Te_3$, SiGe, PbTe, and $CoSb_3$; ternary alloys, such as $Bi_{2-x}Sb_xTe_3$ (0<x<2), $CoSb_{3-x}Te_x$ (0<x<3), and $Co_{4-x}Sb_{12}Fe_x$ (0<x<4); quaternary alloys, such as $Bi_{2-x}Sb_xSe_yTe_{3-y}$ (0<x<2, 0<y<3); doped alloys, such as $Si_{80}Ge_{20}P_x$ (0<x<5); and so on.

Once the thermoelectric alloy has been prepared, it is ball milled under an inert atmosphere or vacuum to produce alloy nanopowders with an average grain size of 5 - 30 nm (for example 5 - 20 nm or 8 - 30 nm). The ball milling can be performed in any conventional ball mill devices, such as Pulveristte 4 Vario-Planetary Mill manufactured by FRITSCH. The optimal operational parameters of the ball mill to produce alloy nanopowders with an average grain size of 5 - 30 nm can be determined from several tests by those skilled in the art based on the general knowledge. As used herein, the average grain size means the average size of single crystals in the powders, which can be measured by X-Ray Diffractometry (XRD) or Transmission Electron Microscopy (TEM).

According to the invention wherein a mechanical alloying process is employed to produce a thermoelectric alloy, the alloying step and the ball milling step are

2. High pressure sintering

1) The milled nanopowders are pressed into a preform under an inert atmosphere or vacuum. The pressure in this step is not critical and depends on the alloy material and the press device. For example, in one embodiment of the present invention, the pressure is between 10 MPa and 50 MPa.

2) The preform is placed into a high pressure sintering mold and subjected to a sintering process under a pressure of 1.0 - 5 GPa, preferably 2.0 - 4 GPa at a temperature of $0.25T_m$ - $0.8T_m$ (preferably $0.25T_m$ - $0.6T_m$, more preferably $0.25T_m$ - $0.4T_m$) to obtain a nanocrystalline bulk thermoelectric material having a relative density of 90 - 100 % (preferably 95 - 100 %) and an average grain size of 10 nm - 50 nm (e.g. 15 nm - 40 nm or 10 nm - 30 nm). As used herein, the relative density means the ratio of the actual density of a material (as measured e.g. by the well-known buoyancy method) to its theoretical density. In order to obtain sufficient sintering, the sintering time should be sufficiently long and no less than 10 minutes (e.g. no less than 15 minutes or no less than 30 minutes). On the other hand, in order to prevent the overgrowth of the grains in the material, the sintering time should be no more than 120 minutes (e.g. no more than 90 minutes or no more than 60 minutes).

3) Measurement of thermoelectric properties of nanocrystalline bulk thermoelectric materials

A sample is cut from the fabricated nanocrystalline bulk thermoelectric material, and tested with TC-7000 Laser Flash Thermal Constants Analyzer (ULVAC-RIKO Inc., Japan) and ZEM-3 Seebeck Coefficient Analyzer (ULVAC-RIKO Inc., Japan) for thermal conductivity and electrical properties.

Nanocrystalline bulk thermoelectric materials are mainly characterized by the Seebeck coefficient $\alpha$, electrical conductivity $\sigma$, thermal conductivity $\kappa$, and ZT value. The bulk thermoelectric material fabricated according to the method of the present invention has a low thermal conductivity and high ZT value. The ZT value can be higher than 2, preferably higher than 2.5.

The various embodiments of the present invention may, but do not necessarily, achieve one or more of the following advantages:

1) The method according to the invention is easy to operate. The operational parameters are easy to control. In the first step, the thermoelectric alloys can be produced by conventional methods, such as melting and mechanical alloying. The mechanical alloying process has the advantages of simple and environmentally friendly.

2) The ball milling process is simple and it is easy to control the size distribution of the resulting nanopowders.

3) The high pressure sintering process is cost effective since it is carried out at a relatively low temperature for a relatively short period. The fabricated materials are highly densified with small and uniformly distributed grain size.

4) The present invention permits the production of a thermoelectric material having a ZT value higher than 2, which represents a significant breakthrough in the field of thermoelectric materials. To date, most commercial available thermoelectric materials have a ZT value lower than 1.4, resulting in low thermoelectric conversion efficiency. Therefore, the present invention may greatly increase the thermoelectric conversion efficiency of a thermoelectric device, making thermoelectric generation a new energy source which is promising and environmentally friendly and allowing the replacement of the traditional cooling process with thermoelectric refrigeration to reduce the emission of Freon.

The various embodiments of the present invention will be described below by way of examples. The scope of the present invention is not limited to these examples.

EXAMPLES

Example 1: Fabrication 1 of High Performance Nanocrystalline Bulk N-typed Binary $Bi_2Te_3$ Thermoelectric Alloy

1) Elemental Bi (99.999%) and elemental Te (99.999%) were weighed in a total amount of 20 g according to the stoichiometric ratio of $Bi_2Te_3$, and placed into a tungsten carbide ball-milling jar. Ball milling was performed under Ar atmosphere using alcohol as the milling media in Pulverisette 4 Vario-Planetary Mill (manufactured by FRITSCH) to produce $Bi_2Te_3$ alloy powder. The milling parameters were set as follows.

Ball-to-powder ratio: 20:1

Disc rotation speed: 300 RPM

Vial rotation speed: 900 RPM

Milling time: 100 hours

The resulted nanopowder was determined by XRD to have an average grain size of about 10 nm.

2) The nanopowder as milled was placed into a glove box, vacuumed, and then pressed into a preform with a thickness of 3 mm in a die (diameter = 10.8 mm) of a press.

3) The preform was placed into a high-pressure mold made of pyrophyllite and graphite, and sintered in a cubic hinge press. The sintering process was carried out as follows. First, the pressure and temperature were increased to about 2 GPa and about 280°C, respectively, and maintained for about 30 minutes. Then, the pressure and temperature were lowered to about 1 GPa and about 250°C, respectively, and maintained for about 30 minutes. The resulted nanocrystalline bulk thermoelectric material had a relative density of about 93% and an average grain size of about 30 nm, as determined by XRD and TEM.

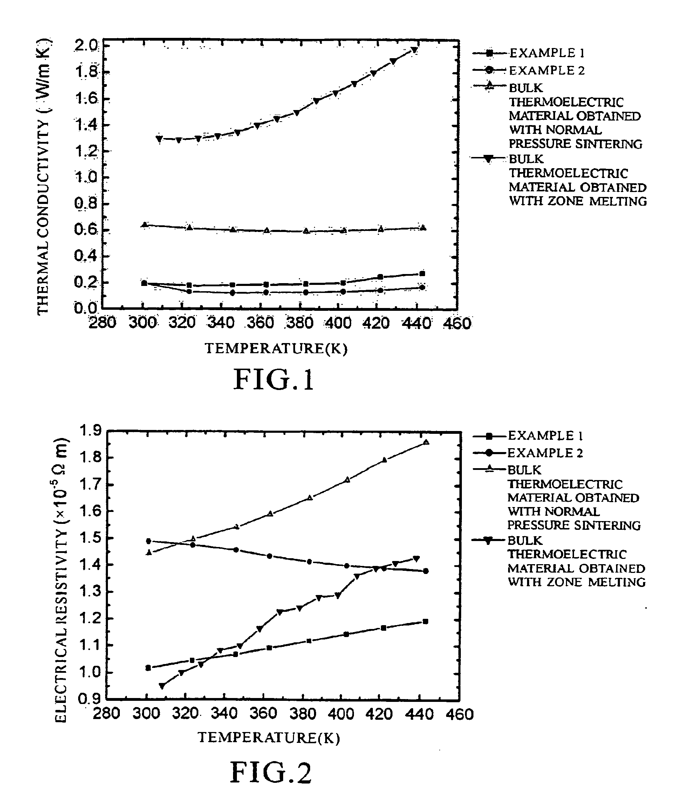

4) Samples were cut from the high pressure sintered nanocrystalline bulk thermoelectric material and tested on TC-7000 Laser Flash Thermal Constants Analyzer (ULVAC-RIKO Inc., Japan) and ZEM-3 Seebeck Coefficient Analyzer (ULVAC-RIKO Inc., Japan) for the thermal conductivity and electrical properties. The ZT value was calculated according to the equation $ZT = \alpha^2 \sigma T / \kappa$. The data were plotted against temperature, as shown in Figs. 1-4.

Example 2: Fabrication 2 of High Performance Nanocrystalline Bulk N-typed Binary $Bi_2Te_3$ Thermoelectric Alloy

1) Elemental Bi (99.999%) and elemental Te (99.999%) were weighed in a total amount of 20 g according to the stoichiometric ratio of $Bi_2Te_3$, and sealed into a quartz tube under vacuum. The quartz tube was placed into an electric furnace to prepare $Bi_2Te_3$ alloy by melting process with the following set up.

Temperature rising rate: 20°C/minute

Melting temperature: 750°C

Temperature holding time: 15 hours

Cooling rate: 2°C/minute

The resulting $Bi_2Te_3$ alloy was pulverized and placed into a tungsten carbide ball-milling jar. Ball milling was performed under Ar atmosphere using alcohol as the milling media in Pulverisette 4 Vario-Planetary Mill (manufactured by FRITSCH) to produce $Bi_2Te_3$ alloy powder. The milling parameters were set as follows.

Ball-to-powder ratio: 20:1

Disc rotation speed: 300 RPM

Vial rotation speed: 900 RPM

Milling time: 100 hours

The resulted nanopowder was determined by XRD to have an average grain size of about 15 nm.

2) The nanopowder as milled was placed into a glove box, vacuumed, and then pressed into a preform with a thickness of 3 mm in a die (diameter = 10.8 mm) of a press.

3) The preform was placed in to a high-pressure mold made up of pyrophyllite and graphite, and sintered in a cubic hinge press. The sintering process was carried out as follows. First, the pressure and temperature were increased to about 2 GPa and about 280°C, respectively, and maintained for about 30 minutes. Then, the pressure and temperature were lowered to about 1 GPa and about 250°C, respectively, and maintained for about 30 minutes. The resulted nanocrystalline bulk thermoelectric material had a relative density of about 100% and an average grain size of about 50 nm, as determined by XRD and TEM.

4) Samples were cut from the sintered nanocrystalline bulk thermoelectric material and tested on TC-7000 Laser Flash Thermal Constants Analyzer (ULVAC-RIKO Inc., Japan) and ZEM-3 Seebeck Coefficient Analyzer (ULVAC-RIKO Inc., Japan) for the thermal conductivity and electrical properties. The ZT value was calculated according to the equation $ZT = \alpha^2 \sigma T / \kappa$. The data were plotted against temperature, as shown in Figs. 1-4.

Example 3: Fabrication of High Performance Nanocrystalline Bulk P-typed Ternary $Bi_{0.5}Sb_{1.5}Te_3$ Thermoelectric Alloy

1) Elemental Bi (99.999%), elemental Sb (99.999%), and elemental Te (99.999%) were weighed in a total amount of 20 g according to the stoichiometric ratio of $Bi_{0.5}Sb_{1.5}Te_3$, and placed into a tungsten carbide ball-milling jar. Ball milling was performed under Ar atmosphere using alcohol as the milling media in Pulverisette 4 Vario-Planetary Mill (manufactured by FRITSCH) to produce $Bi_{0.5}Sb_{1.5}Te_3$ alloy powder. The milling parameters were set as follows.

Ball-to-powder ratio: 20:1

Disc rotation speed: 300 RPM

Vial rotation speed: 900 RPM

Milling time: 100 hours

The resulted powder was determined by XRD to have an average grain size of about 17 nm.

2) The nanopowder as milled was placed into a glove box, vacuumed, and then pressed into a preform with a thickness of 3 mm in a die (diameter = 10.8 mm) of a press.

3) The preform was placed in to a high-pressure mold made up of pyrophyllite and graphite, and sintered in a cubic hinge press. The sintering process was carried out by increasing the pressure and temperature to about 4 GPa and about 380°C, respectively, and holding for about 15 minutes. The resulted nanocrystalline bulk thermoelectric material had a relative density of about 96% and an average grain size of about 38 nm, as determined by XRD and TEM.

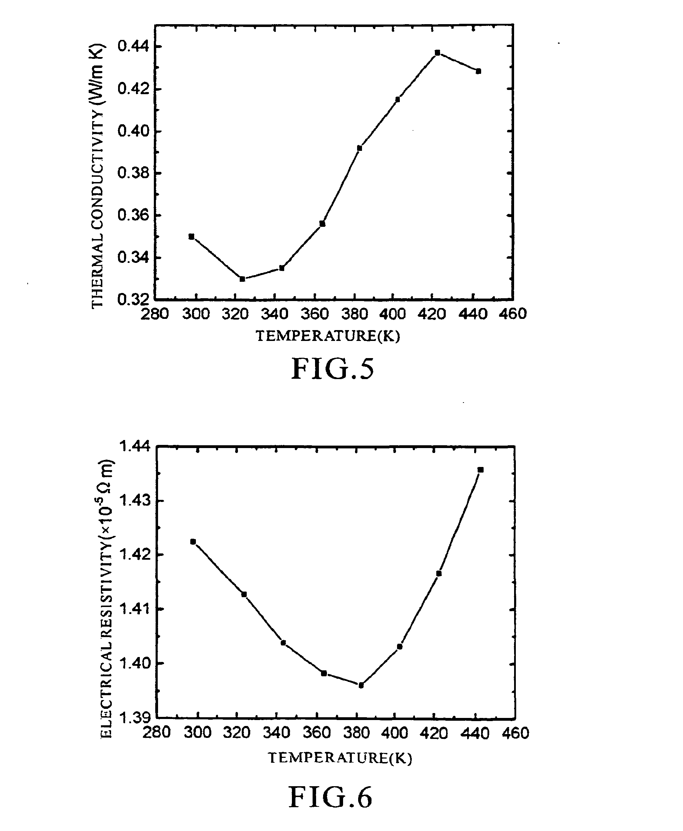

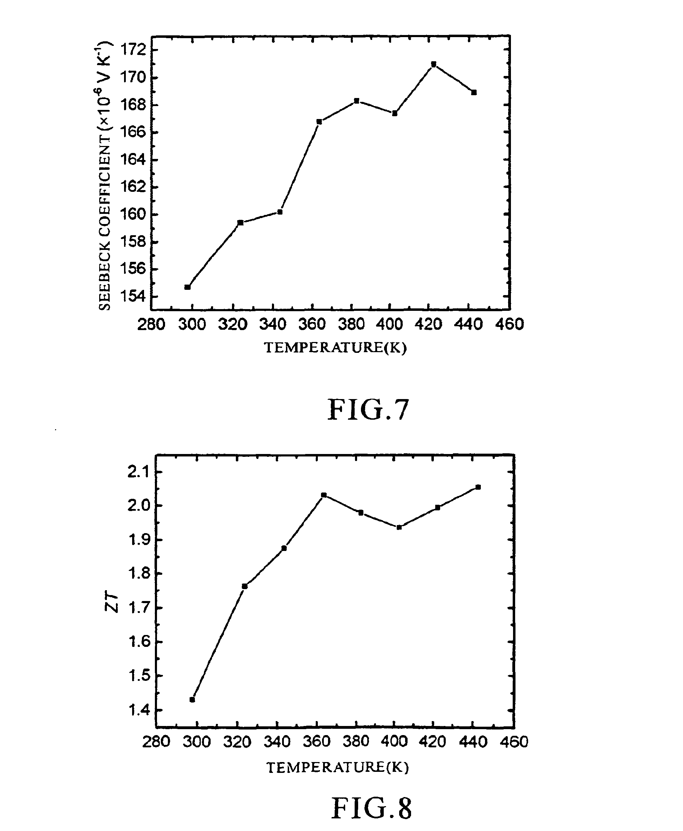

4) Samples were cut from the high pressure sintered nanocrystalline bulk thermoelectric material and tested on TC-7000 Laser Flash Thermal Constants Analyzer (ULVAC-RIKO Inc., Japan) and ZEM-3 Seebeck Coefficient Analyzer (ULVAC-RIKO Inc., Japan) for the thermal conductivity and electrical properties. The ZT value was calculated according to the equation $ZT = \alpha^2 \sigma T / \kappa$. The data were plotted against temperature, as shown in Figs. 5-8.

Example 4: Fabrication of High Performance Nanocrystalline Bulk N-typed Ternary $Si_{80}Ge_{20}P_2$ Thermoelectric Alloy

1) Elemental Si (99.99%), elemental Ge (99.99%), and elemental P (99.99%) were weighed in a total amount of 20 g according to the stoichiometric ratio of $Si_{80}Ge_{20}P_2$, and placed into a tungsten carbide ball-milling jar. Ball milling was performed under Ar atmosphere using alcohol as the milling media in Pulverisette 4 Vario-Planetary Mill (manufactured by FRITSCH) to produce $Si_{80}Ge_{20}P_2$ alloy powder. The milling parameters were set as follows.

Ball-to-powder ratio: 20:1

Disc rotation speed: 200 RPM

Vial rotation speed: 1000 RPM

Milling time: 70 hours

The resulted powder was determined by XRD to have an average grain size of about 12 nm.

2) The nanopowder as milled was placed into a glove box, vacuumed, and then pressed into a preform with a thickness of 3 mm in a die (diameter = 10.8 mm) of a press.

3) The preform was placed in to a high-pressure mold made up of pyrophyllite and graphite, and sintered in a cubic hinge press. The sintering process was carried out by increasing the pressure and temperature to about 3 GPa and about 600°C, respectively, and holding for about 30 minutes. The resulted nanocrystalline bulk thermoelectric material had a relative density of about 98% and an average grain size of about 30 nm, as determined by XRD and TEM.

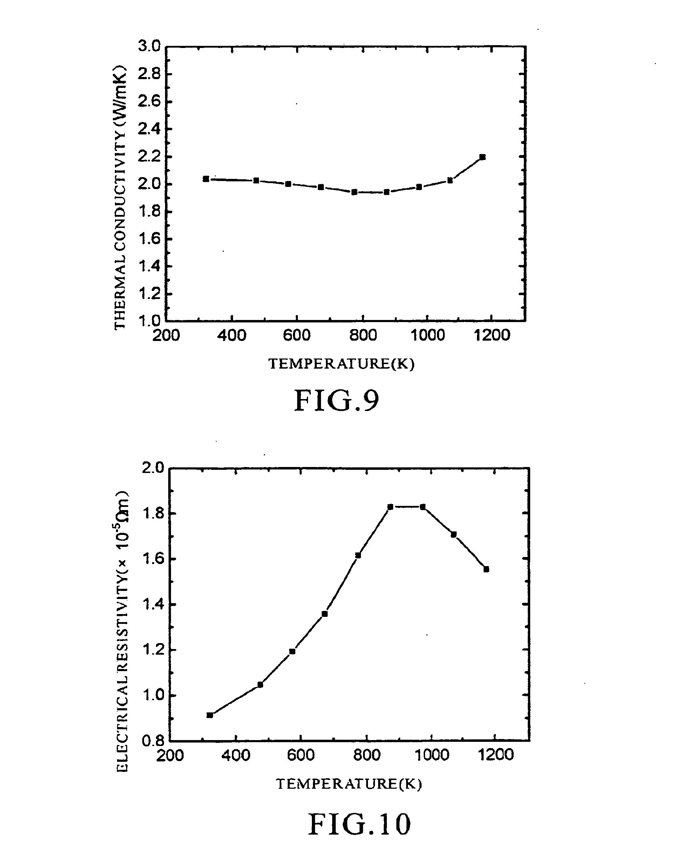

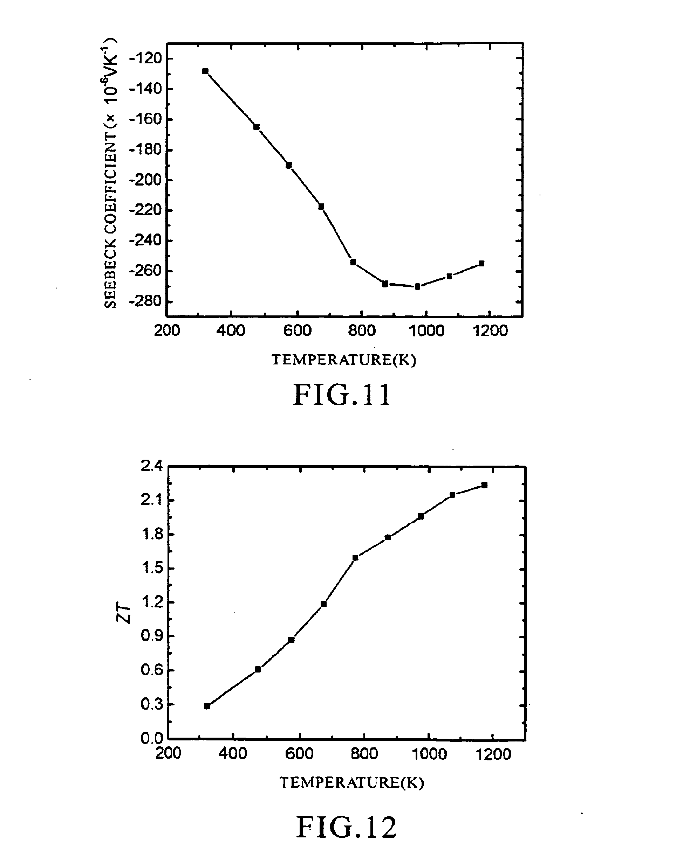

4) Samples were cut from the high pressure sintered nanocrystalline bulk thermoelectric material and tested on TC-7000 Laser Flash Thermal Constants Analyzer (ULVAC-RIKO Inc., Japan) and ZEM-3 Seebeck Coefficient Analyzer (ULVAC-RIKO Inc., Japan) for the thermal conductivity and electrical properties. The ZT value was calculated according to the equation $ZT = \alpha^2 \sigma T / \kappa$. The data were plotted against temperature, as shown in Figs. 9-12.

Example 5: Fabrication of High Performance Nanocrystalline Bulk N-typed Binary PbTe Thermoelectric Alloy

1) Elemental Pb (99.9%) and elemental Te (99.999%) were weighed in a total amount of 20 g according to the stoichiometric ratio of PbTe, and placed into a tungsten carbide ball-milling jar. Ball milling was performed under Ar atmosphere using alcohol as the milling media in Pulverisette 4 Vario-Planetary Mill (manufactured by FRITSCH) to produce $Bi_2Te_3$ alloy powder. The milling parameters were set as follows.

Ball-to-powder ratio: 20:1

Disc rotation speed: 300 RPM

Vial rotation speed: 1200 RPM

Milling time: 100 hours

The resulted powder was determined by XRD to have an average grain size of about 13 nm.

2) The nanopowder as milled was placed into a glove box, vacuumed, and then pressed into a preform with a thickness of 3 mm in a die (diameter = 10.8 mm) of a press.

3) The preform was placed in to a high-pressure mold made up of pyrophyllite and graphite, and sintered in a cubic hinge press. The sintering process was carried out as follows. First, the pressure and temperature were increased to about 2 GPa and about 500°C, respectively, and maintained for about 20 minutes. Then, the pressure and temperature were lowered to about 1 GPa and about 400°C, respectively, and maintained for about 20 minutes. The resulted nanocrystalline bulk thermoelectric material had a relative density of about 97% and an average grain size of about 40 nm, as determined by XRD and TEM.

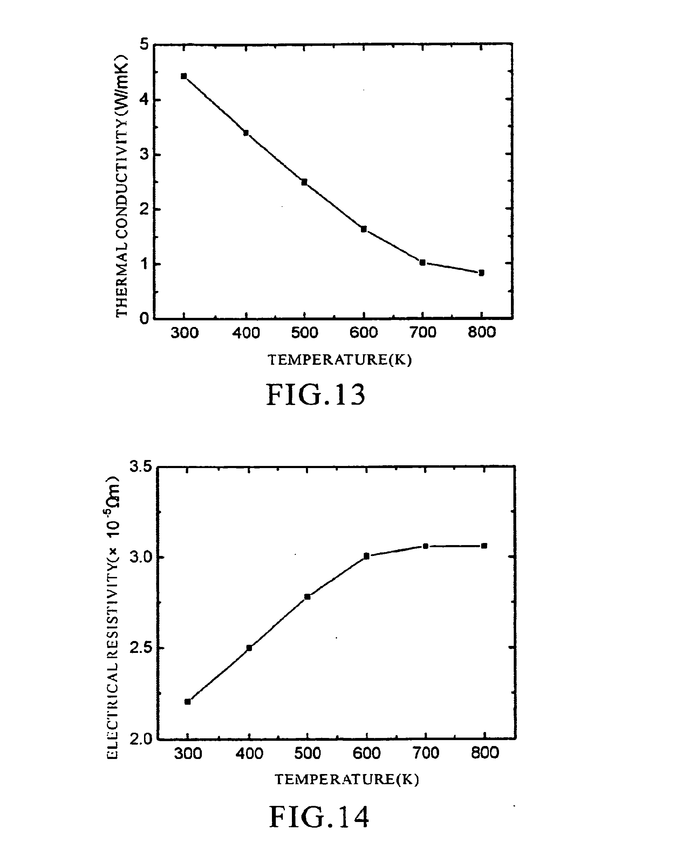

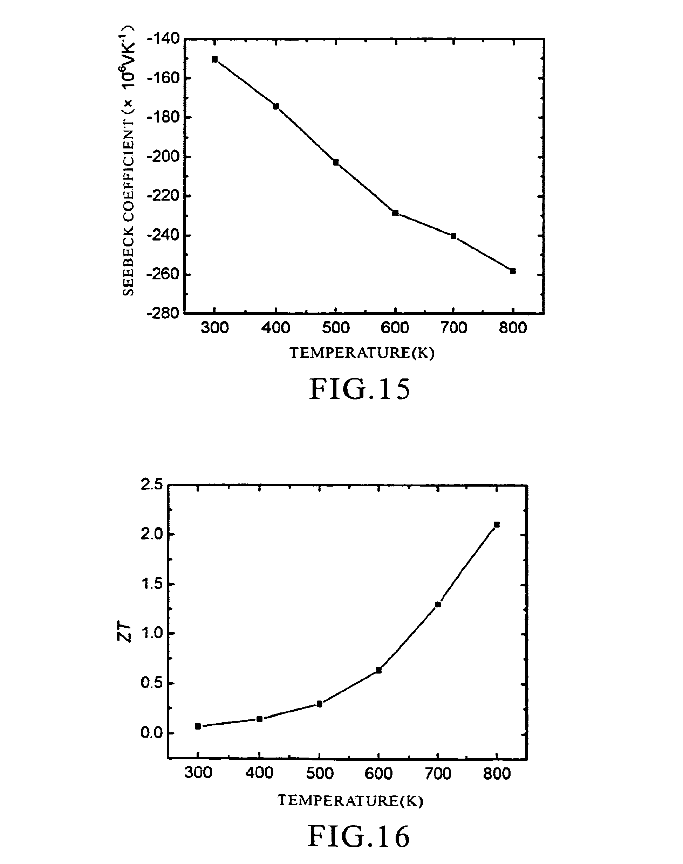

4) Samples were cut from the high pressure sintered nanocrystalline bulk thermoelectric material and tested on TC-7000 Laser Flash Thermal Constants Analyzer (ULVAC-RIKO Inc., Japan) and ZEM-3 Seebeck Coefficient Analyzer (ULVAC-RIKO Inc., Japan) for the thermal conductivity and electrical properties. The ZT value was calculated according to the equation $ZT = \alpha^2 \sigma T/\kappa$. The data were plotted against temperature, as shown in Figs. 13-16.

Example 6: Fabrication of High Performance Nanocrystalline Bulk N-typed Skutterudite CoSb$_3$ Thermoelectric Alloy

1) Elemental Co (99.8%) and elemental Sb (99.999%) were weighed in a total amount of 20 g according to the stoichiometric ratio of Co:Sb=1:3, and mixed together. The mixture was sealed into a quartz tube under vacuum and sintered at about 700 °C for about 20 hours to form homogeneous CoSb$_3$. Then the resulted CoSb$_3$ was placed into a tungsten carbide ball-milling jar. Ball milling was performed under Ar atmosphere using alcohol as the milling media in GN-2 Model Ball Mill to produce CoSb$_3$ alloy powder. The milling parameters were set as follows.

Ball-to-powder ratio: 20:1

Rotation speed: 400 RPM

Milling time: 50 hours

The resulted powder was determined by XRD to have an average grain size of about 5 nm.

2) The nanopowder as milled was placed into a glove box, vacuumed, and then pressed into a preform with a thickness of 3 mm in a die (diameter = 10.8 mm) of a press.

3) The preform was placed in to a high-pressure mold made up of pyrophyllite and graphite, and sintered in a cubic hinge press. The sintering process was carried out as follows. The sintering process was carried out by increasing the pressure and temperature to about 4 GPa and about 550°C, respectively, and holding for about 15 minutes. The resulted nanocrystalline bulk thermoelectric material had a relative density of about 99% and an average grain size of about 45 nm, as determined by XRD and TEM.

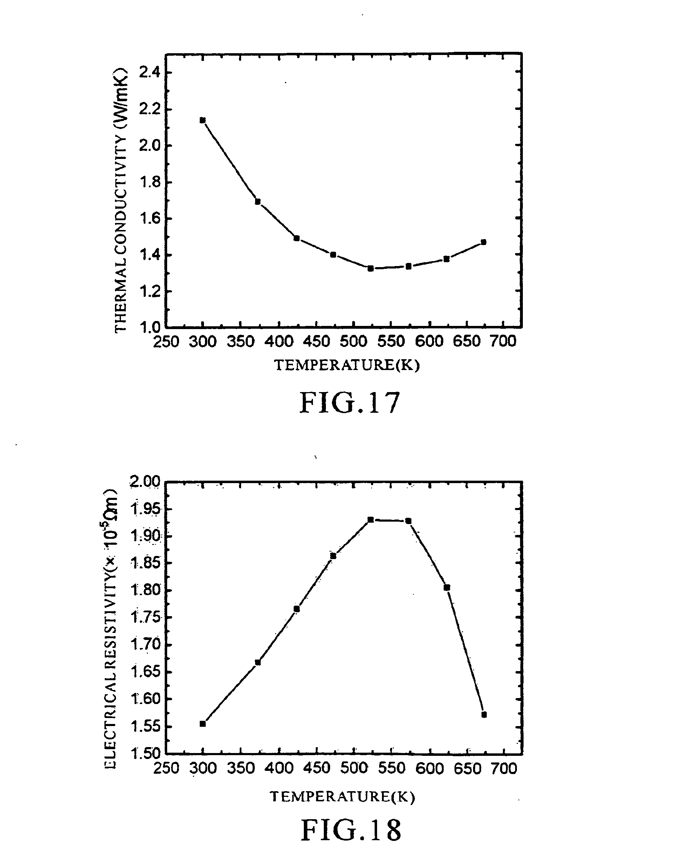

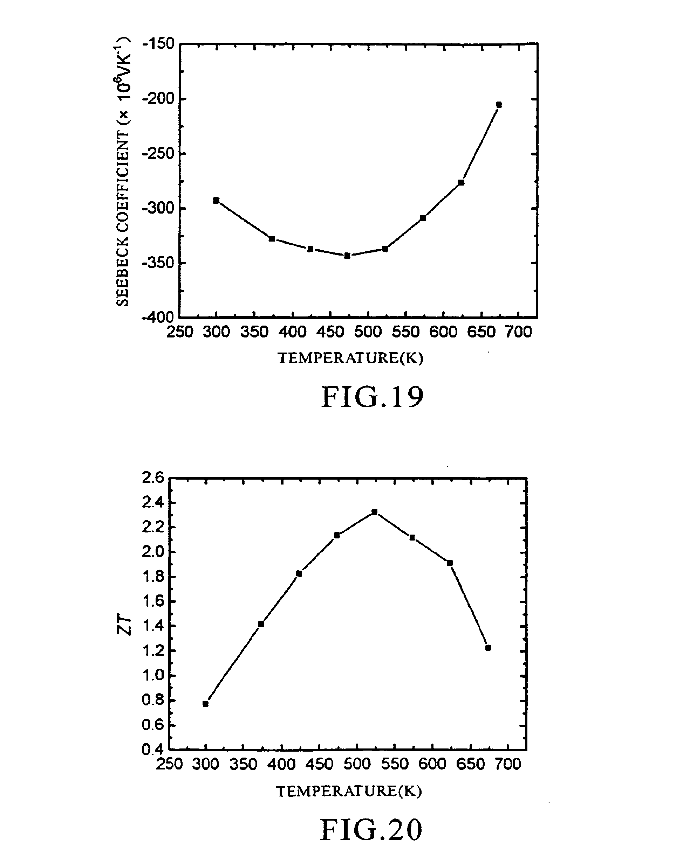

4) Samples were cut from the high pressure sintered nanocrystalline bulk thermoelectric material and tested on TC-7000 Laser Flash Thermal Constants Analyzer (ULVAC-RIKO Inc., Japan) and ZEM-3 Seebeck Coefficient Analyzer (ULVAC-RIKO Inc., Japan) for the thermal conductivity and electrical properties. The ZT value was calculated according to the equation $ZT = \alpha^2 \sigma T/\kappa$. The data were plotted against temperature, as shown in Figs. 17-20.

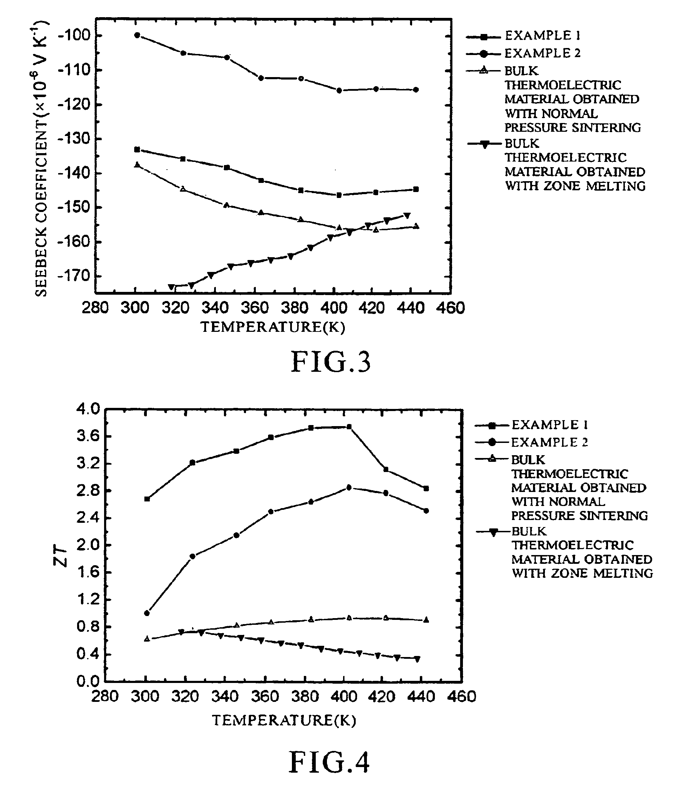

It can be concluded from Figs. 4, 8, 12, 16 and 20 that the above Examples 1-6 all produced a thermoelectric material having a ZT value higher than 2. As can be seen from Fig. 4, the thermoelectric material obtained according to the present invention has a ZT value 5 times higher than that for the material obtained by zone melting process, and also higher than that for the material obtained by normal pressure sintering process. The technique of high pressure sintering opens the door to extensive commercial applications in the fields of energy conversion.

While the invention has been described with respect to a number of embodiments and examples, those skilled in the art, with benefit from this disclosure, will appreciate that other embodiments can be realized. For example, to facilitate the understanding and practicing of the present invention, the specification provides some specific data for the operational parameters, including crystal grain size, time sintering time, sintering temperature, sintering pressure, pressing pressure, and annealing temperature. However, those skilled in the art would understand that these data are preferred values only. In fact, those skilled in the art could adjust these values or value ranges depending on the specific requirements of operational environment, and practice the present invention under operational parameters beyond the specified ranges without departure from the scope of the present invention.

The phrases, unless otherwise specified, "comprise", "include", "including" and "comprising" do not exclude the presence of other steps, elements, or materials, whether or not, specifically mentioned in this specification, as along as such steps, elements, or materials, do not affect the basic and novel characteristics of the invention. For example, the method for the preparation of high performance densified nanocrystalline bulk thermoelectric material according to one embodiment of the invention further include an annealing step under an inert atmosphere or vacuum after the completion of the high pressure sintering step in order to eliminate the residual stress in the material.

For the sake of brevity, only certain ranges are explicitly disclosed herein. However, it should be appreciated that ranges from any lower limit to any upper limit are contemplated unless otherwise indicated. All numerical values take into account experimental error and variations that would be expected by those skilled in the art.

## Claims

1. A method for the fabrication of high performance densified nanocrystalline bulk thermoelectric material, comprising the following steps;

   1) Preparation of nanopowders
   Preparing a thermoelectric alloy with a melting point of $T_m$ by a mechanical alloying process using the corresponding elemental substances as raw materials and simultaneously ball milling the alloy under an inert atmosphere or vacuum to produce alloy powders with an average grain size of 5 - 30 nm;
   2) High pressure sintering

   a) Pressing the milled powder into a preform under an inert atmosphere or vacuum;
   b) Placing the preform into a high pressure sintering mold and sintering the preform at a temperature of 0.25 - 0.8 $T_m$ under a pressure of 1.0 - 5.0 GPa for 10 - 120 minutes, to obtain a nanocrystalline bulk thermoelectric material having a relative density of 90 - 100 % and an average grain size of 10 - 50 nm; and
   c) Performing an annealing step after the high pressure sintering step.

2. The method according to Claim 1, wherein the thermoelectric alloy is selected from the group consisting of $(Bi, Sb)_2(Te, Se)_3$ based materials, PbTe based materials, $Bi_{1-x}Sb_x$ solid solutions (0<x<1), SiGe based alloys, and Skutterudte crystalline compounds.

3. The method according to Claim 1, wherein the thermoelectric alloy is a binary alloy selected from $Bi_2Te_3$, SiGe, PbTe, and $CoSb_3$; a ternary alloy selected from $Bi_{2-x}Sb_xTe_3$ (0<x<2), $CoSb_{3-x}Te_x$ (0<x<3), and $Co_{4-x}Sb_{12}Fe_x$ (0<x<4); a quaternary alloy selected from $Bi_{2-x}Sb_xSe_yTe_{3-y}$ (0<x<2, 0<y<3); or a doped alloy selected from $Si_{80}Ge_{20}P_x$ (0<x<5).

4. The method according to Claim 1, wherein the elemental substances comprise at least one of Bi, Te, Sb, Se, Pb, Co, Si, Ge, Fe, Cd, Sn, La, Ce, Ag, Sr, and P.

5. The method according to Claim 1, wherein the elemental to substances have a purity higher than 94%.

6. The method according to Claim 1, wherein the elemental substances have a purity higher than 99%.

7. The method according to Claim 1, wherein the elemental substances have a purity higher than 99.9%.

8. The method according to Claim 1, wherein the sintering process in step 2)b) is carried out for 10 - 120 minutes.

9. The method according to Claim 1, wherein the thermoelectric alloy is selected from the group consisting of $Bi_2Te_3$, $Bi_{2-x}Sb_xTe_3$ (0<x<2), $Si_{80}Ge_{20}P_2$, PbTe, and $CoSb_3$.

## Patentansprüche

1. Ein Verfahren für die Herstellung von leistungsstarkem, verdichteten, nanokristallinen, thermoelektrischen Bulk-Material, wobei das Verfahren die folgenden Schritte aufweist;

   1) Vorbereitung von Nanopulvern
   Vorbereiten einer thermoelektrischen Legierung mit einem Schmelzpunkt von $T_m$ durch einen mechanischen Legierungsprozess unter Verwendung entsprechender elementarer Substanzen als Rohmaterialien und gleichzeitigem Mahlen der Legierung mit einer Kugelmühle in einer inerten Atmosphäre oder in Vakuum zum Produzieren von Legierungspulvern mit einer mittleren Korngröße von 5 - 30 nm;
   2) Hochdrucksintern

   a) Pressen des gemahlenen Pulvers in eine Vorform in einer inerten Atmosphäre oder in Vakuum;
   b) Platzieren der Vorform in eine Hochdrucksinterpressform und Sintern der Vorform bei einer Temperatur von 0,25 - 0,8 $T_m$ unter einem Druck von 1,0 - 5,0 GPa für 10 -120 Minuten zum Erhalten eines nanokristallinen, thermoelektrischen Bulk-Materials, das eine relative Dichte von 90 - 100 % und eine mittlere Korngröße von 10 - 50 nm aufweist; und
   c) Durchführen eines Wärmebehandlungsschritts nach dem Hochdrucksinterschritt.

2. Das Verfahren gemäß Anspruch 1, wobei die thermoelektrische Legierung ausgewählt wird aus der Gruppe bestehend aus $(Bi, Sb)_2(Te, Se)_3$ basierten Materialien, PbTe basierten Materialien, $Bi_{1-x}Sb_x$ Mischkristallen (0 < x < 1), SiGe basierten Legierungen und Skutterudte-kristallinen Verbindungen.

3. Das Verfahren gemäß Anspruch 1, wobei die thermoelektrische Legierung eine binäre Legierung ist, die ausgewählt wird aus $Bi_2Te_3$, SiGe, PbTe und $CoSb_3$; eine ternäre Legierung ist, die ausgewählt wird aus $Bi_{2-x}Sb_x Te_3$ (0 < x < 2), $CoSb_{3-x}Te_x$ (0 < x < 3) und $Co_{4-x}Sb_{12}Fe_x$ (0 < x < 4); eine quaternäre Legierung ist, die ausgewählt wird aus

$Bi_{2-x}Sb_xSe_yTe_{3-y}$ (0 < x < 2, 0 < y < 3); oder eine dotierten Legierung ist, die ausgewählt wird aus $Si_{80}Ge_{20}P_x$ (0<x<5).

4. Das Verfahren gemäß Anspruch 1, wobei die elementaren Substanzen zumindest ein Element aus der Gruppe aufweisen, die umfasst: Bi, Te, Sb, Se, Pb, Co, Si, Ge, Fe, Cd, Sn, La, Ce, Ag, Sr und P.

5. Das Verfahren gemäß Anspruch 1, wobei die elementaren Substanzen eine Reinheit größer als 94 % aufweisen.

6. Das Verfahren gemäß Anspruch 1, wobei die elementaren Substanzen eine Reinheit größer 99 % aufweisen.

7. Das Verfahren gemäß Anspruch 1, wobei die elementaren Substanzen eine Reinheit größer 99,9 % aufweisen.

8. Das Verfahren gemäß Anspruch 1, wobei der Sinterprozess in Schritt 2) b) für 10 -120 Minuten ausgeführt wird.

9. Das Verfahren gemäß Anspruch 1, wobei die thermoelektrische Legierung ausgewählt wird aus einer Gruppe bestehend aus: $Bi_2Te_3$, $Bi_{2-x}Sb_xTe_3$ (0 < x < 2), $Si_{80}Ge_{20}P_2$, PbTe und $CoSb_3$.

## Revendications

1. Procédé de fabrication d'un matériau thermoélectrique nanocristallin en vrac densifié haute performance, comprenant les étapes suivantes :

> 1) Préparation de nanopoudres
> Préparation d'un alliage thermoélectrique ayant un point de fusion $T_m$, par un procédé d'alliage mécanique utilisant les substances élémentaires correspondantes en tant que matières premières, et simultanément broyage au broyeur à billes de l'alliage sous une atmosphère inerte ou sous vide pour produire des poudres d'alliage ayant une granulométrie moyenne de 5-30 nm ;
> 2) Frittage sous haute pression
>
> > a) Pressage de la poudre broyée pour former un comprimé, sous atmosphère inerte ou sous vide ;
> > b) Mise en place du comprimé dans un moule de frittage sous haute pression, et frittage du comprimé à une température de 0,25-0,8 $T_m$ sous une pression de 1,0-5,0 GPa pendant 10-120 minutes, pour obtenir un matériau thermoélectrique nanocristallin en vrac ayant une densité relative de 90-100 % et une granulométrie moyenne de 10-50 nm ; et
> > c) Mise en oeuvre d'une étape de recuit après l'étape de frittage sous haute pression.

2. Procédé selon la revendication 1, dans lequel l'alliage thermoélectrique est choisi dans le groupe consistant en les matériaux à base de $(Bi,Sb)_2(Te,Se)_3$, les matériaux à base de PbTe, les solutions solides de $Bi_{1-x}Sb_x$ (0<x<1), les alliages à base de SiGe et les composés cristallins à base de skuddérudite.

3. Procédé selon la revendication 1, dans lequel l'alliage thermoélectrique est un alliage binaire choisi parmi $Bi_2Te_3$, SiGe, PbTe et $CoSb_3$ ; un alliage ternaire choisi parmi $Bi_{2-x}Sb_xTe_3$ (0<x<2), $CoSb_{3-x}Te_x$ (0<x<3) et $Co_{4-x}Sb_{12}Fe_x$ (0<x<4) ; un alliage quaternaire choisi parmi $Bi_{2-x}Sb_xSe_yTe_{3-y}$ (0<x<2, 0<y<3) ; ou un alliage dopé choisi parmi $Si_{80}Ge_{20}P_x$ (0<x<5).

4. Procédé selon la revendication 1, dans lequel les substances élémentaires comprennent au moins l'un de Bi, Te, Sb, Se, Pb, Co, Si, Ge, Fe, Cd, Sn, La, Ce, Ag, Sr et P.

5. Procédé selon la revendication 1, dans lequel les substances élémentaires ont une pureté supérieure à 94 %.

6. Procédé selon la revendication 1, dans lequel les substances élémentaires ont une pureté supérieure à 99 %.

7. Procédé selon la revendication 1, dans lequel les substances élémentaires ont une pureté supérieure à 99,9 %.

8. Procédé selon la revendication 1, dans lequel l'opération de frittage de l'étape 2)b) est mise en oeuvre pendant 10-120 minutes.

9. Procédé selon la revendication 1, dans lequel l'alliage thermoélectrique est choisi dans le groupe consistant en $Bi_2Te_3$, $Bi_{2-x}Sb_xTe_3$ (0<x<2), $Si_{80}Ge_{20}P_2$, PbTe et $CoSb_3$.

FIG.1

FIG.2

FIG.3

FIG.4

FIG.5

FIG.6

FIG.7

FIG.8

FIG.9

FIG.10

FIG.11

FIG.12

FIG.13

FIG.14

FIG.15

FIG.16

FIG.17

FIG.18

FIG.19

FIG.20

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20080202575 A1

- EP 1074512 A1

**Non-patent literature cited in the description**

- **VENTKATASUBRAMANIAN et al.** Thin-Film Thermoelectric Devices With High Room-Temperature Figures Of Merit. *Nature,* 2001, vol. 413, 597
- **HARMAN et al.** Quantum Dot Superlattice Thermoelectric Materials and Devices. *Science,* 2002, vol. 297, 2229
- **HARMAN et al.** Nanostructured Thermoelectric Materials. *Journal of Electronic Materials,* 2005, vol. 34, L19

- **F. YU et al.** Enhanced thermoelectric figure of merit in nanocrystalline Bi2Te3 bulk. *J. of Appl. Phys,* 01 May 2009, vol. 105 (094303), 1-5
- **T. SU et al.** Enhanced thermoelectric performance of AgSbTe2 synthesized by high pressure and high temperature. *J. of Appl. Phys,* 15 April 2009, vol. 105 (073713), 1-4